# EUROPÄISCHE PATENTANMELDUNG

(11) **EP 4 380 187 A1**
(43) Veröffentlichungstag der Anmeldung: **05.06.2024**
(21) Anmeldenummer: 23213570.7
(22) Anmeldetag: 01.12.2023
(51) Int. Cl.: H04R 1/24, H04R 9/06, H04R 17/00, H04R 1/10, H04R 7/12

(54) **SCHALLWANDLEREINHEIT**

(30) Priorität: 02.12.2022 DE 102022132092; 23.12.2022 DE 102022134731; 17.02.2023 DE 102023104021
(71) Anmelder: USound GmbH, 8020 Graz (AT)
(72) Erfinder: RUSCONI CLERICI BELTRAMI, Andrea, 1130 Wien (AT); BOTTONI, Ferruccio, 8020 Graz (AT); Spoetl, Jakob, 1120 Wien (AT); Novotny, Christian, 1120 Wien (AT)
(74) Vertreter: Canzler & Bergmeier Patentanwälte Partnerschaft mbB

(57) **Zusammenfassung**

Die Erfindung betrifft eine Schallwandlereinheit (1), insbesondere für einen In-Ear Hörer, mit einem elektrodynamischen Schallwandler (2), der eine erste Membran (10), vorzugsweise mit einem Membrandurchbruch (42), aufweist, und mit zumindest einem MEMS-Schallwandler (3), der eine zweite Membran (30) aufweist. Erfindungsgemäß umfasst die Schallwandlereinheit (1) ein Schallleitelement (16), mittels dem vom MEMS-Schallwandler (3) erzeugte Schallwellen am elektrodynamischen Schallwandler (2), insbesondere an der ersten Membran (10) des elektrodynamischen Schallwandlers (2), vorbeigeführt werden können.

## Beschreibung

Die vorliegende Erfindung betrifft eine Schallwandlereinheit, insbesondere für einen In-Ear Kopfhörer, mit einem elektrodynamischen Schallwandler, der eine erste Membran mit einem Membrandurchbruch aufweist, und mit zumindest einem MEMS-Schallwandler, der eine zweite Membran aufweist.

In der WO 2022/121740 A1 ist eine Schallwandlereinheit mit einem elektrodynamischen und einem MEMS-Schallwandler offenbart.

Aufgabe der vorliegenden Erfindung ist es, eine kompakte Schallwandlereinheit aus einem elektrodynamischen und MEMS-Schallwandler zu schaffen.

Die Aufgabe wird gelöst durch eine Schallwandlereinheit, ein Elektronikbauteil und die Verwendung der Schallwandlereinheit gemäß den unabhängigen Patentansprüchen.

Vorgeschlagen wird eine Schallwandlereinheit, insbesondere für einen In-Ear Kopfhörer oder -Hörer, mit einem elektrodynamischen Schallwandler, der eine erste Membran mit einem Membrandurchbruch aufweist, und mit zumindest einem MEMS-Schallwandler, der eine zweite Membran aufweist. Die Schallwandlereinheit kann hierbei auch für andere Elektronikbauteile eingesetzt werden. Ein Elektronikbauteil kann der bereits beschriebene In-Ear Hörer sein, aber auch ein Smartphone, Laptop, Tablet, Smartwatch usw.

Des Weiteren umfasst die Schallwandlereinheit ein Schallleitelement, mittels dem vom MEMS-Schallwandler erzeugte Schallwellen am elektrodynamischen Schallwandler vorbeigeführt werden können. Hierbei können die vom MEMS-Schallwandler erzeugte Schallwellen auch an der ersten Membran des elektrodynamischen Schallwandlers vorbeigeführt werden. Hierdurch wird eine gegenseitige Beeinflussung der vom MEMS-Schallwandler erzeugten Schallwellen und der vom elektrodynamischen Schallwandler erzeugten Schallwellen verhindert. Die Schallwellen des MEMS-Schallwandlers und des elektrodynamischen Schallwandlers bleiben voneinander getrennt. Hierdurch können Resonanzen, Beugungen und/oder Interferenzen der vom MEMS-Schallwandler erzeugten Schallwellen am elektrodynamischen Schallwandler, an der ersten Membran und/oder mit Schallwellen des elektrodynamischen Schallwandlers vermieden werden.

Vorteilhafterweise ist der MEMS-Schallwandler derart in den elektrodynamischen Schallwandler integriert, dass die von der zweiten Membran erzeugbaren Schallwellen über den Membrandurchbruch aus der Schallwandlereinheit ausführbar sind. Hierdurch kann die Schallwandlereinheit kompakt ausgebildet werden. Durch den Membrandurchbruch werden die Schallwellen des MEMS-Schallwandlers ausgeleitet, so dass diese nur wenig gestört werden und die Tonqualität hoch bleibt.

Ebenso bringt es Vorteile mit sich, wenn der elektrodynamische Schallwandler um den zumindest einen MEMS-Schallwandler herum angeordnet ist. Der elektrodynamische Schallwandler umschließt somit den MEMS-Schallwandler. Der MEMS-Schallwandler ist im Inneren des elektrodynamischen Schallwandlers angeordnet, so dass die Schallwandlereinheit kompakt ausgebildet ist.

Ferner ist es vorteilhaft, wenn die erste Membran ringförmig ausgebildet ist. Hierdurch können mit der ersten Membran des elektrodynamischen Schallwandlers Schallwellen mit wenigen Verzerrungen abgestrahlt werden. Insbesondere ist die erste Membran scheibenförmig mit einem, vorzugsweise runden, Loch, insbesondere in der Mitte, ausgebildet.

Vorteilhaft ist es zudem, wenn der elektrodynamische Schallwandler ringförmig ausgebildet ist. Hierdurch weist der elektrodynamische Schallwandler ein Durchgangsloch auf, durch das zumindest die Schallwellen des MEMS-Schallwandlers zumindest teilweise geführt werden können. Der elektrodynamische Schallwandler kann auch die Form eines Torus aufweisen.

Ferner ist es vorteilhaft, wenn der MEMS-Schallwandler in einem Durchgangsloch des als ring ausgebildeten elektrodynamischen Schallwandlers angeordnet ist. Infolgedessen ist die Schallwandlereinheit kompakt ausgebildet, da der MEMS-Schallwandler im Inneren des elektrodynamischen Schallwandlers angeordnet ist. Die Größe der Schallwandlereinheit wird somit durch die Größe des elektrodynamischen Schallwandlers vorgegeben. Wenn der elektrodynamische Schallwandler die Form eines Torus aufweist, kann der MEMS-Schallwandler auch in einem Durchgangsloch des Torus angeordnet sein. Hierbei kann es auch so sein, dass die Form des elektrodynamischen Schallwandlers der Form eines Torus ähneln kann. Der elektrodynamische Schallwandler kann eine torusähnliche Form aufweisen.

Die Schallwandlereinheit umfasst ein Schallleitelement. Mit Hilfe des Schallleitelements können die vom MEMS-Schallwandler erzeugten Schallwellen geleitet werden. Das Schallleitelement kann beispielsweise ein Schallleitrohr oder ein Schallleitkanal sein. Zusätzlich oder alternativ ist es von Vorteil, wenn sich das Schallleitelement durch den elektrodynamischen Schallwandler und/oder durch den Membrandurchbruch, somit auch durch die erste Membran, hindurch erstreckt. Mittels des Schallleitelements können die Schallwellen des MEMS-Schallwandlers am elektrodynamischen Schallwandler und/oder an der ersten Membran des elektrodynamischen Schallwandlers und/oder an anderen Bauteilen vorbeigeführt werden. Infolgedessen können Resonanzen, Beugungen und/oder Interferenzen am elektrodynamischen Schallwandler, an der ersten Membran und/oder mit Schallwellen des elektrodynamischen Schallwandlers vermieden werden.

Vorteile bringt es zudem mit sich, wenn das Schallleitelement über die erste Membran übersteht und/oder als Fortsatz ausgebildet ist, der über die erste Membran hinausragt. Infolgedessen können die Schallwellen des MEMS-Schallwandlers an der ersten Membran vorbeigeführt werden.

Ferner ist es vorteilhaft, wenn das Schallleitelement gerade oder gekrümmt ist. Dadurch kann der Schall des MEMS-Schallwandlers an eine gewünschte Position geführt werden.

Von Vorteil ist es, wenn an einer Außenseite des Schallleitelements zumindest ein Abstandshalter angeordnet ist. Mit Hilfe des Abstandshalter kann bei vorgesehener Anordnung der Schallwandlereinheit in einem Elektronikbauteil das Schallleitelement von einem umgebenden Gehäuseteils des Elektronikbauteils beabstanden werden. Wenn es sich beim Elektronikbauteil um einen In-Ear-Hörer handelt, kann das Gehäuseteil ein Ohrteil sein. Zusätzlich oder alternativ kann mittels des zumindest einen Abstandshalters das Schallleitelement zum Gehäuseteil in Position gehalten bzw. fixiert bleiben. Hierdurch wird gewährleistet, dass der Schall stets in einer definierten Richtung abgegeben wird, wenn die Schallwellen das Schallleitelement verlassen.

Weiterhin ist es von Vorteil, wenn der zumindest eine Abstandshalter labyrinthförmig ausgebildet ist. Zusätzlich oder alternativ ist es vorteilhaft, wenn der zumindest eine Abstandshalter helixförmig ausgebildet ist. Der zumindest eine Abstandshalter kann auch zick-zack-förmig ausgebildet sein. Hierdurch kann erreicht werden, dass der Schall, der am Schallleitelement vorbei geleitet wird, also die Schallwellen des elektrodynamischen Schallwandlers, auf eine Helixbahn bzw. das Labyrinth des labyrinthförmigen Abstandshalters gezwungen werden. Hiermit kann eine Tonqualität beeinflusst werden, da damit eine Laufzeit der Schallwellen, eine Lautstärke und/oder ein Frequenzspektrum der Schallwellen angepasst werden können.

Vorteilhaft ist es des Weiteren, wenn an der Außenseite des Schallleitelements ein Dämpfungsmaterial angeordnet ist. Zusätzlich oder alternativ kann das Dämpfungsmaterial auch am zumindest einen Abstandshalter angeordnet sein. Vorzugsweise ist das Dämpfungsmaterial zwischen dem Schallleitelement und einem, insbesondere bei vorgesehener Anordnung der Schallwandlereinheit, umgebenden Gehäuseteil, Ohrteil, Gehäuse oder Abschnitt des Elektronikbauteils angeordnet. Mit Hilfe des Dämpfungsmaterials können die vom elektrodynamischen Schallwandler ausgesendeten Schallwellen gedämpft und/oder deren Klang beeinflusst werden.

Ebenso ist es vorteilhaft, wenn die Schallwandlereinheit einen Wandlerhohlraum aufweist, in dem der MEMS-Schallwandler und/oder eine Elektronikeinheit angeordnet ist. Der Wandlerhohlraum kann hierbei zumindest teilweise durch das Durchgangsloch des ringförmigen elektrodynamischen Schallwandlers ausgebildet sein. Der Wandlerhohlraum kann im Inneren des elektrodynamischen Schallwandlers angeordnet sein, so dass die Schallwandlereinheit kompakt ausgebildet ist. Der Wandlerhohlraum dient hierbei als Aufnahmeraum für den MEMS-Schallwandler und/oder die Elektronikeinheit.

Vorteilhaft ist es, wenn der Wandlerhohlraum von einer Magneteinheit, insbesondere eines Magneten, des elektrodynamischen Schallwandlers in Radialrichtung umrandet ist. Dabei kann die Magneteinheit den Wandlerhohlraum unmittelbar umranden. Die Magneteinheit begrenzt somit den Wandlerhohlraum. Hierdurch werden weitere Bauteile eingespart, so dass die Schallwandlereinheit kompakt und mit geringem Gewicht ausgebildet werden kann.

Zusätzlich oder alternativ ist es von Vorteil, wenn der MEMS-Schallwandler und/oder die Elektronikeinheit in Axialrichtung der Schallwandlereinheit auf Höhe der Magneteinheit, insbesondere des Magneten, angeordnet ist. Die Magneteinheit, insbesondere der Magnet, erstreckt sich somit in Radialrichtung um den MEMS-Schallwandler und/oder die Elektronikeinheit. Die Magneteinheit, insbesondere der Magnet, und der MEMS-Schallwandler und/oder die Elektronikeinheit überdecken sich somit in Axialrichtung der Schallwandlereinheit zumindest teilweise, insbesondere vollständig.

Vorteilhaft ist es, wenn der MEMS-Schallwandler, die Elektronikeinheit, der Halter und/oder das Schallleitelement in Axialrichtung der Schallwandlereinheit einen Überdeckungsbereich mit einer Magneteinheit, insbesondere einem Magneten, des elektrodynamischen Schallwandlers, einer Spule des elektrodynamischen Schallwandlers und/oder eines Wandlergehäuses der Schallwandlereinheit aufweisen. In Axialrichtung überdecken sich somit beispielsweise der MEMS-Schallwandler und die Magneteinheit, insbesondere der Magnet. Die Magneteinheit, insbesondere der Magnet, umgibt somit den MEMS-Schallwandler, wobei sich beide in Axialrichtung zumindest in einem Abschnitt überdecken.

Ebenso ist es vorteilhaft, wenn der MEMS-Schallwandler am Halter der Schallwandlereinheit und/oder an der Magneteinheit, insbesondere am ersten Polelement, des elektrodynamischen Schallwandlers angeordnet ist. Zusätzlich oder alternativ können der MEMS-Schallwandler und der Halter und/oder die Magneteinheit, insbesondere das erste Polelement, eine Kontaktfläche aufweisen. Vorzugsweise ist der MEMS-Schallwandler mit dem Halter und/der der Magneteinheit, insbesondere dem ersten Polelement, verbunden. Beispielsweise ist der MEMS-Schallwandler mit dem Halter und/der der Magneteinheit, insbesondere dem ersten Polelement, zusammengeklebt. Die Kontaktfläche kann hierbei zumindest teilweise eine Klebefläche sein.

Vorteile bringt es mit sich, wenn die Elektronikeinheit eine Elektronikdurchführung aufweist, die sich an eine MEMS-Kavität des MEMS-Schallwandlers anschließt. Die Elektronikdurchführung dient dazu, dass ein Druckausgleich bei der Bewegung der zweiten Membran stattfinden kann. Mittels der Elektronikdurchführung kann eine Verbindung zu einem Hintervolumen des MEMS-Schallwandlers oder des In-Ear-Hörers hergestellt bzw. das Hintervolumen ausgebildet werden.

Ferner ist es vorteilhaft, wenn eine Schallausbreitungsachse des elektrodynamischen Schallwandlers und eine Schallausbreitungsachse des MEMS-Schallwandlers zueinander koaxial angeordnet sind, insbesondere in Axialrichtung der Schallwandlereinheit.

Von Vorteil ist es, wenn die Schallwandlereinheit zumindest ein Dichtungselement aufweist. Das zumindest eine Dichtungselement kann an einer Umgangsseite der Schallwandlereinheit angeordnet sein. Hiermit kann die Schallwandlereinheit in ein Gehäuse, beispielsweise ein Ohrteil, des Elektronikbauteils eingesetzt werden, so dass keine Feuchtigkeit und/oder kein Schall an der Schallwandlereinheit vorbei gelangt. Insbesondere kann damit die Schallwandlereinheit zwei Räume derart voneinander trennen, dass diese dicht für Feuchtigkeit und/oder die Schallwellen sind. Das Dichtungselement kann beispielsweise ein Dichtring sein, der vorzugsweise aus Gummi oder einem Silikon ausgebildet ist.

Vorteilhaft ist es, wenn die Schallwandlereinheit zumindest einen Anschluss umfasst. Des Weiteren kann auch die Elektronikeinheit und/oder eine Leiterplatte den zumindest einen Anschluss aufweisen. Über den zumindest einen Anschluss können elektrische Signale und/oder eine Stromversorgung zur Schallwandlereinheit geführt werden. Hierbei kann der zumindest eine Anschluss als ein flexibler Anschlussabschnitt ausgebildet sein. Der Anschluss kann beispielsweise als eine Flex-PCB ausgebildet sein. Der Anschluss kann dann gedreht werden, so dass die Verbindung aus verschiedenen Richtungen ausgebildet werden kann. Zusätzlich oder alternativ kann der zumindest eine Anschluss auch als Stecker ausgebildet sein. Beispielsweise kann auch ein Stecker und ein flexibler Anschlussabschnitt angeordnet sein. Über den Stecker kann beispielsweise eine elektrische Stromversorgung erfolgen und über den flexiblen Anschlussabschnitt können die elektrischen Signale geführt werden.

Von Vorteil ist es, wenn die Schallwandlereinheit zumindest ein Mikrofon aufweist, mittels dem zumindest die vom elektrodynamischen Schallwandler erzeugbaren Schallwellen und/oder Umgebungsgeräusche erfasst werden können. Mit Hilfe der Erfassung der Schallwellen des elektrodynamischen Schallwandlers kann überwacht werden, ob dieser korrekt funktioniert und/oder ob die Schallwellen eine hohe Tonqualität aufweisen. Wenn die Umgebungsgeräusche erfasst werden, kann damit Active-Noise-Cancelling durchgeführt werden. Es wird ein Antischall erzeugt, der die Umgebungsgeräusche auslöscht und so unterdrückt.

Vorgeschlagen wird ferner eine Schallwandlereinheit, insbesondere für einen In-Ear Hörer, mit einem elektrodynamischen Schallwandler, der eine erste Membran aufweist, und mit zumindest einem MEMS-Schallwandler, der eine zweite Membran aufweist. Die Schallwandlereinheit kann zumindest ein Merkmal der vorangegangenen und/oder nachfolgenden Beschreibung aufweisen.

Vorgeschlagen wird ein Elektronikbauteil, insbesondere In-Ear-Hörer, mit einer Schallwandlereinheit gemäß der vorangegangenen Beschreibung, wobei die genannten Merkmale einzeln oder beliebiger Kombination vorhanden sein können. Beim Elektronikbauteil kann es sich auch um ein Smartphone, Tablet, Laptop usw. handeln.

Vorteilhaft ist es, wenn das Elektronikbauteil eine Auslassöffnung aufweist und/oder dass sich ein Schallleitelement von einem Membrandurchbruch bis zur Auslassöffnung erstreckt. Das Schallleitelement führt somit die Schallwellen des MEMS-Schallwandlers durch das Elektronikbauteil. Eine Wechselwirkung der vom MEMS-Schallwandler erzeugten Schallwellen mit einem Inneren des Elektronikbauteils wird somit vermieden.

Vorgeschlagen wird die Verwendung einer Schallwandlereinheit in einem Elektronikbauteil. Vorteilhafterweise ist die Schallwandlereinheit und/oder das Elektronikbauteil gemäß der vorangegangenen und/oder nachfolgenden Beschreibung ausgebildet, wobei die genannten Merkmale einzeln oder in Kombination vorhanden sein können.

Die Schallwandlereinheit kann einen Tieftöner, einen Hochtöner, eine Elektronikeinheit und ein Schallleitelement für beispielsweise In-Ear-Hörer oder auch In-Ear-Telefone umfassen. Der Tieftöner kann eine "Donut"-Form aufweisen, mit einem offenen Raum und/oder einem Durchgangsloch und/oder dem Wandlerhohlraum, vorzugsweise in der Mitte. In diesen Raum ist der MEMS-Hochtöner eingesetzt.

An den Hochtöner wird ein Schallleitelement ("Schallführung") angeschlossen, um den Schall vom Hochtöner direkter an den Ausgang des In-Ear-Hörers bzw. des Elektronikbauteils zu leiten. Dies ist akustisch sinnvoll, da so die hohen Frequenzen des Hochtöners ungefiltert und ungestört vom Schall des Tieftöners die Auslassöffnung des In-Ear-Hörers bzw. des Elektronikbauteils erreichen können.

Die Elektronikeinheit kann direkt unter dem Hochtöner angebracht werden und sorgt für die notwendige Verstärkung des Audiosignals für den Hochtöner.

Zumindest ein Mikrofon (für Active-Noise-Cancelling) kann über eine Flexplatine bzw. eine PCB kann in einem Bereich neben dem Schallleitelement angeordnet werden. Hierbei umfasst die Schallwandlereinheit das zumindest eine Mikrofon. Das Mikrofon kann dem elektrodynamischen Schallwandler zugeordnet sein, so dass das Mikrofon die vom elektrodynamischen Schallwandler erzeugten Schallwellen erfassen kann. Hierdurch kann die Tonqualität überwacht werden. Zusätzlich oder alternativ können mit Hilfe des Mikrofons auch Umgebungsgeräusche erfasst werden. Daraus kann ein Antischall gebildet werden, der vom elektrodynamischen Schallwandler und/oder vom MEMS-Schallwandler erzeugt werden kann, um die Umgebungsgeräusche auszulöschen, so dass die Umgebungsgeräusche unterdrückt werden.

Das Schallleitelement (Schallführung) kann den Klang des Hochtöners direkt zum Ausgang des In-Ear-Hörers bzw. des Elektronikbauteils leiten. Das Schallleitelement wird von einer Struktur bzw. einem Halter gehalten, die/der an den Klang des Tieftöners angepasst sein kann. Dies wird eine einfache Feinabstimmung ermöglichen. Außerdem wird es die Verwendung von 2 verschiedenen Dämpfungsmaterialien ermöglichen:
- Am Ausgang des Schallleitelements kann ein Standard-Mesh-Material angebracht werden. Dadurch wird eine gewisse Reibung (Dämpfung) auf beiden Schallwegen, sowohl beim Tieftöner als auch beim Hochtöner, erreicht.
- Zwischen Abstandshaltern zwischen dem Schallleitelement und einem Ohrteil bzw. Gehäuseteil und dem Abdichtelement kann ein Schaumstoff angebracht werden, um den Tieftöner zusätzlich zu dämpfen.

Die Kombination des elektrodynamischen Tieftöners und des MEMS-Hochtöners ist eine koaxiale Bauweise für einen In-Ear-Hörer bzw. -Telefonanwendung oder auch für das Elektronikbauteil.

Ein "donutförmiger" elektrodynamischer Tieftöner mit einem integrierten MEMS-Hochtöner in der Mitte bilden einen koaxialen Lautsprecher für eine In-Ear-Hörer, In-Ear-Telefone oder für Elektronikbauteile.

Ein elektrodynamischer Tieftöner mit einem ringförmigen Magneten und einem integrierten MEMS-Hochtöner in der Mitte, die einen Koaxiallautsprecher für eine In-Ear-Hörer bzw. -Telefonanwendung oder für Elektronikbauteile bilden.

Ein "donutförmiger" elektrodynamischer Tieftöner mit einem integrierten MEMS-Hochtöner in der Mitte, der einen Koaxiallautsprecher für eine In-Ear-Hörer bzw. -Telefonanwendung oder für Elektronikbauteile bildet.

Eine Schallwandlereinheit, umfassend einen "donutförmigen" elektrodynamischen Tieftöner, einen integrierten MEMS-Hochtöner in der Mitte und ein Mikrofon, insbesondere ein Rückkopplungsmikrofon, wodurch ein Koaxiallautsprecher für eine In-Ear-Hörer bzw. -Telefonanwendung oder für Elektronikbauteile ausgebildet wird.

Das Schallleitelement kann auch ein Schallschlauch sein oder derart ausgebildet sein.
- Einsetzen eines (MEMS-)Hochtöners in einen "donutförmigen" elektrodynamischen Tieftöner von der Rückseite. Ermöglicht einfache elektrische Anschlüsse an der Rückseite.
- Integration eines MEMS-Hochtöners und einer Elektronikeinheit in ein Inneres eines elektrodynamischen Tieftöners.
- Einbau eines (MEMS-)Hochtöners mit Elektronikeinheit in einen elektrodynamischen Tieftöner von der Rückseite. Ermöglicht einfache elektrische Anschlüsse auf der Rückseite.
- Kombination eines ringförmigen Magneten für den elektrodynamischen Tieftöner mit der Integration des MEMS-Hochtöners in den verfügbaren Platz in der Mitte eines Lautsprechermoduls.
- Einen Halter, der 3 Funktionen vereint: die Aufnahme des Schallleitelements ("Schallführung"), des Innenrings bzw. des inneren Membranträgers der Tieftönermembran und des MEMS-Hochtöners.
- Ein Halter in der Mitte des Schallwandlereinheit, der drei Funktionen vereint: Er hält das Schallleitelement ("Sound Guide"), den Innenring bzw. den inneren Membranträger der Tieftönermembran und den MEMS-Hochtöner. Er ermöglicht es, den Schallweg des Hochtöners und der Tieftonmembran separat zu optimieren. Außerdem stellt es eine effiziente Methode für den Zusammenbau dar.
- Das Schallleitelement, das den Schall direkt an den Ausgang eines In-Ear-Hörers oder des Elektronikbauteils für den Hochtöner weiterleitet.
- Die Ohrhörermuschel bzw. das Ohrteil hat Abstandshalter, die das Schallleitelement in Position halten.
- Die Stege bzw. die Abstandshalter, die die Schallleitelement halten, können in Form und Größe angepasst werden, um die Schallleistung des Tieftöners zu optimieren.
- Die Brücken bzw. die Abstandshalter ermöglichen die Integration von zusätzlichem Dämpfungsschaumstoff in den Schallweg des Tieftöners, zusätzlich zu dem herkömmlichen Ausgangsnetz bzw. des Abdichtelements.

Weitere Vorteile der Erfindung sind in den nachfolgenden Ausführungsbeispielen beschrieben. Es zeigen:
- **Figur 1**: einen Querschnitt einer Schallwandlereinheit mit einem elektrodynamischen und einem MEMS-Schallwandler,
- **Figur 2**: einen Querschnitt des MEMS-Schallwandlers,
- **Figur 3**: einen Querschnitt eines In-Ear Hörer mit der Schallwandlereinheit in einem Hörergehäuse,
- **Figur 4**: einen Querschnitt des elektrodynamischen Schallwandlers,
- **Figur 5**: einen Querschnitt des elektrodynamischen Schallwandlers mit dem MEMS-Schallwandler,
- **Figur 6**: eine Draufsicht auf einen MEMS-Schallwandler,
- **Figur 7**: einen Querschnitt des In-Ear Hörers bzw. der Schallwandlereinheit mit einem Ausführungsbeispiel eines Abstandshalters und mit zumindest einem Dichtelement und
- **Figur 8**: einen Querschnitt einer Schallwandlereinheit mit Mikrofonen.

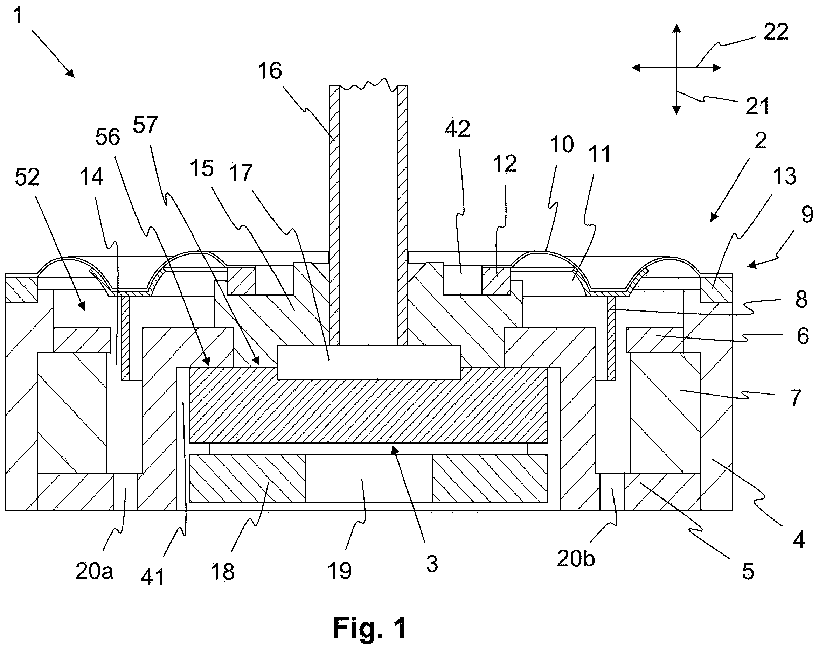

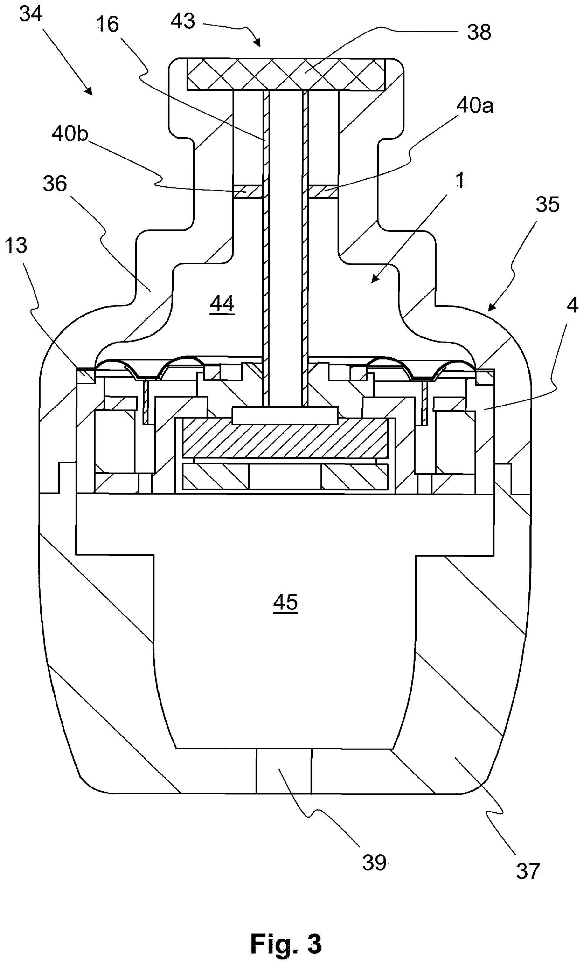

Figur 1 zeigt eine Schallwandlereinheit 1 mit einem elektrodynamischen Schallwandler 2 und einem MEMS-Schallwandler 3. Die Schallwandlereinheit 1 kann beispielsweise in In-Ear Hörer 34 eingesetzt werden. Derartige In-Ear Hörer 34 werden beispielsweise als Hörgeräte, zur Kommunikation, beispielsweise zum Telefonieren, oder zum Musikhören verwendet und eingesetzt. Die In-Ear Hörer 34, wie er in Figur 3 gezeigt ist, kann dabei zumindest teilweise in einen Gehörgang eines Ohres eingesetzt werden. Die Schallwandlereinheit 1 kann auch in Smartphones oder andere Elektronikbauteilen eingesetzt werden. Der in Figur 3 gezeigte In-Ear Hörer 34 ist ein Beispiel eines Elektronikbauteils. Die Schallwandlereinheit 1 kann auch in Kopfhörern, Smartphones, Laptops, Tablets, Smartwatches usw. eingesetzt werden.

Die Schallwandlereinheit 1 weist eine Axialrichtung 21 und eine Radialrichtung 22 auf.

Die Schallwandlereinheit 1 umfasst ein Wandlergehäuse 4. Im Wandlergehäuse 4 sind der elektrodynamische Schallwandler 2 und/oder der MEMS-Schwallwandler 3 zumindest teilweise angeordnet. Der elektrodynamische Schallwandler 2 kann hier auch als Woofer bezeichnet werden, da der elektrodynamische Schallwandler 2 bzw. der Woofer bei der vorliegenden Schallwandlereinheit 1 hauptsächlich dafür vorgesehen ist, um tiefe Töne zu erzeugen. Derartige tiefe Töne weisen beispielsweise eine Frequenz von ca. 20 Hz bis 1000 Hz auf. Der elektrodynamische Schallwandler 2 dient in der vorliegenden Schallwandlereinheit 1 somit als Tieftöner. Dagegen kann der zumindest eine MEMS-Schallwandler 3 in der vorliegenden Schallwandlereinheit 1 als Hochtöner oder auch als Tweeter bezeichnet werden. Der MEMS-Schallwandler 3 erzeugt in der Schallwandlereinheit 1 Schall mit einer Frequenz, die insbesondere höher ist als die des elektrodynamischen Schallwandlers 2 oder des Woofers bzw. des Tieftöners. Beispielsweise erzeugt der MEMS-Schallwandler 3 Schall oder Töne mit einer Frequenz zwischen ungefähr 500 Hz und 20 kHz. In der hier vorliegenden Beschreibung kann somit der elektrodynamische Schallwandler 2 auch als Tieftöner oder Woofer bezeichnet werden. Der MEMS-Schallwandler 3 kann in der vorliegenden Beschreibung auch als Hochtöner oder Tweeter bezeichnet werden.

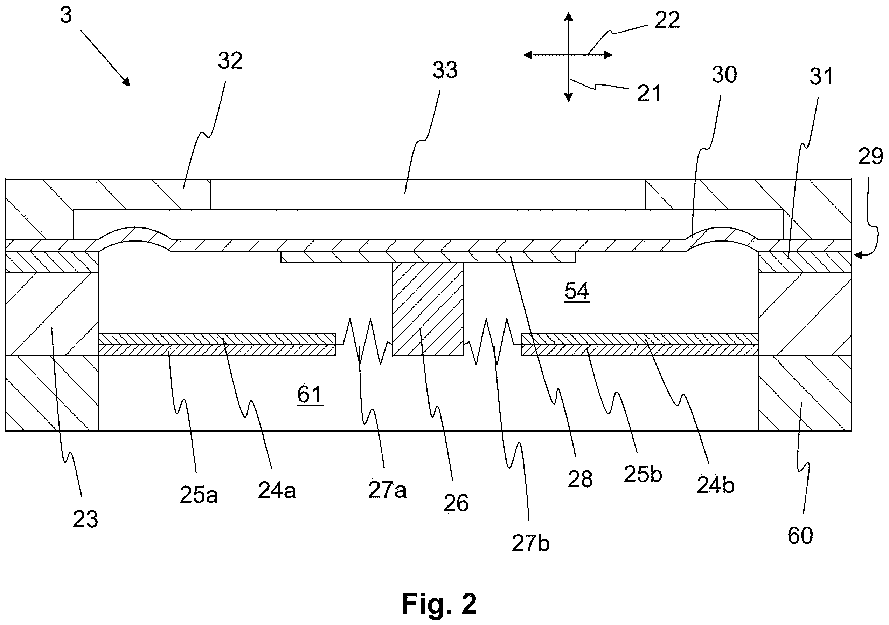

Der MEMS-Schallwandler 3 ist detaillierter in Figur 2 gezeigt.

Der elektrodynamische Schallwandler 2 bzw. der Woofer 2 umfasst zumindest ein Polelement 5, 6. Gemäß dem vorliegenden Ausführungsbeispiel umfasst der Woofer 2 ein erstes und ein zweiter Polelement 5, 6. Zwischen den beiden Polelementen 5, 6 ist ein Magnet 7 angeordnet, der vorzugsweise ein Permanentmagnet ist. Der Magnet 7 erzeugt ein Magnetfeld und die beiden Polelemente 5, 6 führen und/oder bündeln den magnetischen Fluss des Magneten 7. Zumindest das zumindest eine Polelement 5, 6 und der Magnet 7 bilden zusammen eine Magneteinheit 52. Die Magneteinheit 52, insbesondere das zumindest eine Polelement 5, 6 und/oder der Magnet 7, kann ringförmig sein.

Der elektrodynamischen und der MEMS-Schallwandler 2, 3 sind koaxial zueinander angeordnet. Dabei können auch eine Schallausbreitungsrichtung des elektrodynamischen und des MEMS-Schallwandlers 2, 3 zueinander koaxial sein. In der vorliegenden Figur 1 wird der Schall des elektrodynamischen und des MEMS-Schallwandlers 2, 3 in Axialrichtung 21 und hier nach oben abgegeben. Somit sind auch die entsprechenden Schallausbreitungsrichtungen in Axialrichtung 21 und hier nach oben orientiert.

Die beiden hier gezeigten Polelemente 5, 6 sind in einer Axialrichtung 21 der Schallwandlereinheit 1 voneinander beabstandet angeordnet. Zusätzlich oder alternativ sind die beiden Polelemente 5, 6 in einer Radialrichtung 22 der Schallwandlereinheit 1 voneinander beabstandet. Zwischen den beiden in Radialrichtung 22 beabstandeten Polelemente 5, 6 ist ferner ein Magnetspalt 14 angeordnet. Zusätzlich oder alternativ ist der Magnetspalt 14 in Radialrichtung 22 zwischen dem ersten Polelement 5 und dem Magnet 7 angeordnet. In diesen Magnetspalt 14 ist eine Spule 8 des Woofers 2 angeordnet. Die Spule 8 taucht in den Magnetspalt 14 ein. Die Spule 8 wird mit einem elektrischen Signal beaufschlagt und hierdurch von einem elektrischen Strom durchflossen. Das elektrische Signal entspricht dabei den Tönen, die vom elektrodynamischen Schallwandler 2 bzw. vom Woofer 2 erzeugt werden, wenn der elektrodynamische Schallwandler 2 als Lautsprecher betrieben wird. Der durch das elektrische Signal ausgebildete elektrische Strom in der Spule 8 führt ebenfalls zu einem Magnetfeld, welches mit dem Magnetfeld des Magneten 7 und/oder der Polelemente 5, 6 zusammenwirkt. Da der Magnet 7 und/oder die Polelemente 5, 6 fest sind, bewegt sich die Spule 8.

Die Bewegung der Spule 8 wird auf eine Membraneinheit 9 übertragen, wobei die Membraneinheit 9 darüber angeordnete Luft entsprechend der Bewegung der Spule 8 in Schwingung versetzt. Die Membraneinheit 9 erzeugt infolgedessen den Schall.

Die Membraneinheit 9 umfasst zur Schallerzeugung eine erste Membran 10, die mittels einer Koppeleinheit 11 mit der Spule 8 verbunden ist, so dass die Bewegung der Spule 8 auf die erste Membran 10 übertragen werden kann. Da der elektrodynamische Schallwandler 2 hauptsächlich dazu eingesetzt wird, um tiefe Töne zu erzeugen, kann die erste Membran 10 auch als Tieftönermembran bezeichnet werden. Die Membraneinheit 9 umfasst ferner einen inneren Membranträger 12 und einen äußeren Membranträger 13. Der innere Membranträger 12 ist in Radialrichtung 22 innen und der äußere Membranträger 13 ist in Radialrichtung 22 außen angeordnet. Zwischen den beiden Membranträgern 12, 13 ist die erste Membran 10 aufgespannt. Die erste Membran 10 und/oder die Membraneinheit 9 weist somit die Form einer Lochscheibe auf. Die Membraneinheit 9 und/oder die erste Membran 10 weist einen Membrandurchbruch 42 auf, der in einem Mittelbereich, insbesondere der Mitte, der ersten Membran 10 und/oder der Membraneinheit 9 angeordnet ist. Des Weiteren umrandet der innere Membranträger 12 den Membrandurchbruch 42. Der innere und/oder der äußere Membranträger 12, 13 können ringförmig ausgebildet sein. Hierdurch weist die erste Membran 10 eine runde Form mit einem runden Loch in einem Mittelbereich auf. Der äußere Membranträger 13 ist auf dem Wandlergehäuse 4 angeordnet. Der innere Membranträger 12 ist auf dem Halter 15 angeordnet. Die erste Membran 10 bzw. die Membraneinheit 9 können ringförmig sein.

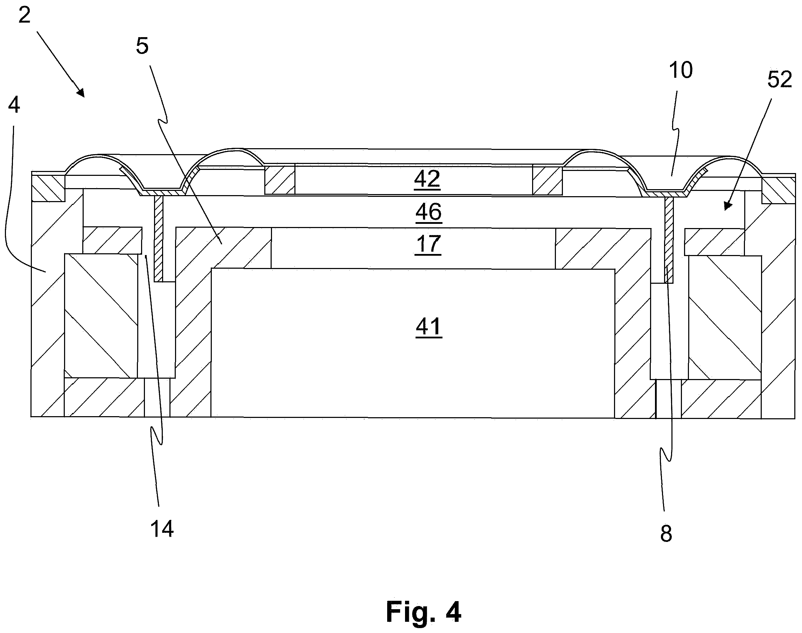

Des Weiteren weist die Schallwandlereinheit 1 einen Wandlerhohlraum 41 auf, in dem der MEMS-Schallwandler 3 angeordnet ist. Hierbei kann auch der Woofer 2 den Wandlerhohlraum 41 aufweisen. Der Wandlerhohlraum 41 ist in Figur 4 besser gezeigt, da darin der MEMS-Schallwandler 3 weggelassen ist. Der Woofer 2 erstreckt sich somit um den MEMS-Schallwandler 3 herum. Der MEMS-Schallwandler 3 ist innerhalb des elektrodynamischen Schallwandlers 2 angeordnet. Der MEMS-Schallwandler 3 ist in der Mitte des elektrodynamischen Schallwandlers 2 angeordnet. Der elektrodynamische Schallwandlers 2 umschließt den MEMS-Schallwandler 3. Hierdurch wird eine sehr kompakte Bauweise der Schallwandlereinheit 1 erreicht.

Gemäß dem vorliegenden Ausführungsbeispiel umschließt das erste Polelement 5 und/oder der Magnet 7 bzw. die Magneteinheit 52 den Wandlerhohlraum 41. Der Wandlerhohlraum 41 ist innerhalb des ersten Polelements 5 und/oder des Magnets 7 bzw. der Magneteinheit 52 angeordnet.

Gemäß dem vorliegenden Ausführungsbeispiel sind zumindest der MEMS-Schallwandler 3 und die Magneteinheit 52, insbesondere der Magnet 7 und/oder das erste Polelement 5, in Axialrichtung 21 der Schallwandlereinheit 1 auf gleicher Höhe angeordnet. Der MEMS-Schallwandler 3 und die Magneteinheit 52, insbesondere der Magnet 7, weisen in Axialrichtung 21 einen Überdeckungsabschnitt auf. In Axialrichtung 21 überdecken sich somit der MEMS-Schallwandler 3 und die Magneteinheit 52, insbesondere der Magnet 7.

Wie ferner in der Figur 1 gezeigt ist, sind der MEMS-Schallwandler 3 und der elektrodynamische Schallwandlers 2 koaxial zueinander angeordnet. Der elektrodynamische Schallwandlers 2 ist in Radialrichtung 22 um den MEMS-Schallwandler 2 angeordnet.

Der elektrodynamische Schallwandler 2, insbesondere die Magneteinheit 52, weist ferner die Form eines Torus auf bzw. ähnelt einem Torus. Alternativ weist der elektrodynamische Schallwandler 2, insbesondere die Magneteinheit 52, eine Ringform auf. Der elektrodynamische Schallwandlers 2 bildet eine äußere Schicht der Schallwandlereinheit 1 und der MEMS-Schallwandler 3 bildet einen Kern. Der elektrodynamische Schallwandlers 2 weist die Form eines Donuts auf. Der Membrandurchbruch 42 und/oder der Wandlerhohlraum 41 und/oder die im Folgenden erläuterte Schallkavität 17 bilden die Öffnung oder das Durchgangsloch des Torus bzw. des Donuts bzw. des elektrodynamischen Schallwandlers 2. Der Membrandurchbruch 42 ist besser in Figur 4 gezeigt. Vorzugsweise wird die Schallkavität 17 so klein wie möglich ausgebildet oder weggelassen, da mit dieser die Tonqualität beeinflusst wird.

Die Schallwandlereinheit 1 umfasst des Weiteren einen Halter 15. Der Halter 15 ist gemäß dem vorliegenden Ausführungsbeispiel am ersten Polelement 5 bzw. an der Magneteinheit 52 angeordnet bzw. liegt auf diesem auf. Am Halter 15 ist ferner der innere Membranträger 12 angeordnet. Der Halter 15 verbindet somit den inneren Membranträger 12 mit dem ersten Polelement 5.

Der Halter 15 stützt den inneren Membranträger 12. Am inneren Membranträger 12 und/oder am ersten Polelement 5 ist ferner der MEMS-Schallwandler 3 zumindest teilweise angeordnet. Am Halter 15 kann der MEMS-Schallwandler 3, das erste Polelement 5, der innere Membranträger 12 und/oder das im Folgenden erläuterte Schallleitelement 16 angeordnet sein. Der Halter 15 ist vorzugsweise aus Kunststoff ausgebildet.

Am Halter 15 ist ferner ein Schallleitelement 16 angeordnet. Beispielsweise kann das Schallleitelement 16 mit dem Halter 15 zusammengeklebt sein. Mit Hilfe des Schallleitelements 16 kann der vom MEMS-Schallwandler 3 erzeugte Schall geleitet werden. Mittels des Schallleitelements 16 werden somit im Vergleich zu den Schallwellen des Woofers 2 höhere Töne geleitet. Mittels des Schallleitelements 16 kann insbesondere der Schall am Schall des elektrodynamischen Schallwandlers 2 vorbeigeleitet werden. Interferenzen oder Beugungen an Bauteilen wird somit vermieden. Gemäß Figur 3 kann somit der Schall des MEMS-Schallwandlers 3 direkt in den Gehörgang abgegeben bzw. zu diesem geleitet werden. Das Schallleitelement 16 kann als Rohr oder Schlauch mit vorzugsweise einem runden Querschnitt ausgebildet sein. Das Schallleitelement 16 kann auch ein Schallleitkanal sein. Das Schallleitelement 16 ist ferner ein Hohlleiter.

Das Schallleitelement 16 ist ferner derart angeordnet, dass die Schallwellen des Woofers 2 um das Schallleitelement 16 herumgeführt werden. Im Schallleitelement 16 werden dagegen die Schallwellen des MEMS-Schallwandlers 3 geleitet. Hierdurch kann das Schallleitelement 16 die Schallwellen des elektrodynamischen Schallwandlers 2 und die Schallwellen des MEMS-Schallwandlers 3 voneinander trennen.

Des Weiteren kann das Schallleitelement 16 koaxial zum Woofer 2 und/oder zum Tweeter 3 angeordnet sein. Das Schalleitelement 16 erstreckt sich durch die Membrandurchführung 42 durch die erste Membran 10 hindurch. Die erste Membran 10 ist um das Schallleitelement 16 angeordnet.

Vorzugsweise sind jedoch der Woofer 2 und der Tweeter 3 zueinander koaxial. Des Weiteren kann das Schallleitelement 16 in Radialrichtung 22 zum Tweeter 3 und/oder Woofer 2 versetzt sein, d.h. außermittig, sein. Dies kann dann vorteilhaft sein, wenn der Platz für andere Bauteile benötigt wird. Mit Hilfe des Schallleitelements 16 kann der Schall des Tweeters 3 an anderen Bauteilen vorbeigeführt werden. Hierfür kann das Schallleitelement 16 in Radialrichtung versetzt werden, so dass es nicht mehr koaxial zum Woofer 2 und/oder Tweeter 3 ist.

Des Weiteren kann eine Schallkavität 17 vorgesehen sein, die hier zwischen MEMS-Schallwandler 3 und dem Schallleitelement 16 angeordnet ist. Diese kann auch zumindest teilweise ein Vordervolumen des Tweeters 3 bilden.

Die Elektronikeinheit 18 weist vorzugsweise eine Elektronikdurchführung 19 auf, die zumindest teilweise ein Hintervolumen des Tweeters 3 bildet. Außerdem kann damit ein Druckausgleich stattfinden.

Um den Druckausgleich zu erreichen, kann zusätzlich oder alternativ das erste Polelement 5 zumindest eine Poldurchführung 20 aufweisen, die als Loch oder Bohrung ausgebildet sein kann. Hier sind mehrere Poldurchführungen 20a, 20b gezeigt.

Wie hier zu sehen ist, ist die Schallwandlereinheit 1 rotationssymmetrisch ausgebildet. Insbesondere der elektrodynamische Schallwandler 2, insbesondere die Magneteinheit 52, der Magnet 7, das erste und/oder zweite Polelement 5, 6, die Spule 7, die Membraneinheit 9, die erste Membran 10 und/oder der innere und/oder der äußere Membranträger 12, 13 sind rund und/oder rotationssymmetrisch. Zusätzlich oder alternativ ist der Halter 15 rund und/oder rotationssymmetrisch. Zusätzlich oder alternativ ist die Koppeleinheit 11 rund und/oder rotationssymmetrisch. Zusätzlich oder alternativ ist das Wandlergehäuse 4 rund und/oder rotationssymmetrisch.

Des Weiteren ist wie hier zu sehen ist, zwischen MEMS-Schallwandler 3 und der Magneteinheit 52, insbesondere dem ersten Polelement 5, eine erste Kontaktfläche 56 angeordnet und/oder ausgebildet. Der MEMS-Schallwandler 3 ist somit an der Magneteinheit 52, insbesondere am ersten Polelement 5, angeordnet. Zusätzlich oder alternativ kann zwischen dem MEMS-Schallwandler 3 und dem Halter 15 eine zweite Kontaktfläche 57 angeordnet und/oder ausgebildet sein. Der MEMS-Schallwandler 3 ist somit am Halter 15 angeordnet.

Der MEMS-Schallwandler 3 kann mittels der ersten und/oder zweiten Kontaktfläche 56, 57 mit der Magneteinheit 52, insbesondere dem ersten Polelement 5, und/oder dem Halter 15 verbunden sein. Die erste und/oder zweite Kontaktfläche 56, 57 können beispielsweise eine Klebefläche sein, so dass der MEMS-Schallwandler 3 an der Magneteinheit 52, insbesondere am ersten Polelement 5, und/oder am Halter 15 angeklebt ist.

Des Weiteren liegt der MEMS-Schallwandler 3 an einer zur ersten Membran 10 abgewandten Seite auf dem Halter 15 und/oder auf der Magneteinheit 52, insbesondere auf dem ersten Polelement 5, auf. Die erste Membran 10 ist somit auf der einen Seiten und der MEMS-Schallwandler 3 auf der anderen Seite des Halters 15 und/oder der Magneteinheit 52, insbesondere des ersten Polelements 5, angeordnet.

Merkmale, welche bereits in der zumindest einen vorgegangenen Figur beschrieben sind, können der Einfachheit halber nicht nochmals erklärt werden. Ferner können Merkmale auch erst in dieser oder in zumindest einer der nachfolgenden Figuren beschrieben werden. Des Weiteren werden der Einfachheit halber für gleiche Merkmale gleiche Bezugszeichen verwendet. Außerdem können der Übersichtlichkeit halber nicht mehr alle Merkmale in den folgenden Figuren gezeigt und/oder mit einem Bezugszeichen versehen sein.

Es können jedoch in einer oder mehreren der vorangegangenen Figuren gezeigte Merkmale auch in dieser oder in einer oder mehreren der nachfolgenden Figuren vorhanden sein. Ferner können der Übersichtlichkeit halber Merkmale auch erst in dieser oder in einer oder mehreren der nachfolgenden Figuren gezeigt und/oder mit einem Bezugszeichen versehen sein. Nichtsdestotrotz können Merkmale, welche erst in einer oder mehreren der nachfolgenden Figuren gezeigt sind, auch bereits in dieser oder einer vorangegangenen Figur vorhanden sein.

Figur 2 zeigt einen Querschnitt des MEMS-Schallwandlers 3. Der Tweeter 3 umfasst ein Trägersubstrat 23 und daran angeordnet zumindest eine Trägerschicht 24. Am Trägersubstrat 23 und/oder an der zumindest einen Trägerschicht 24 ist zumindest eine Piezoschicht 25 angeordnet. Hier weist der Tweeter 3 zwei Trägerschichten 24a, 24b und zwei Piezoschichten 25a, 25b auf. Die zumindest eine Trägerschicht 24 und die zumindest eine Piezoschicht 25 sind in Axialrichtung 21 übereinander angeordnet.

Die zumindest eine Piezoschicht 25 lenkt sich gemäß dem daran angelegten elektrischen Signal aus, wodurch die Luft in Schwingung versetzt wird und hierdurch der Schall erzeugt wird.

Der Tweeter 3 umfasst ferner ein Koppelelement 26, welches über zumindest einem Federelement 27 mit der zumindest einen Piezoschicht 25 und/oder der Trägerschicht 24 verbunden ist. Das Koppelement 26 kann die Auslenkung der zumindest einen Piezoschicht 25 auf eine MEMS-Membraneinheit 29 übertragen. Zwischen Koppelelement 26 und MEMS-Membraneinheit 29 ist eine Koppelplatte 28 angeordnet, so dass die vom Koppelelement 26 übertragene Auslenkung flächig auf die MEMS-Membraneinheit 29 übertragen wird.

Die MEMS-Membraneinheit 29 umfasst zumindest eine zweite Membran 30, die die Luft in Schwingung versetzen kann, so dass der Schall gemäß der Auslenkung der zumindest einen Piezoschicht 25 erzeugt wird. Des Weiteren kann die MEMS-Membraneinheit 29 einen MEMS-Membranrahmen 31 umfassen, auf dem die zweite Membran 30 angeordnet ist. Der MEMS-Membranrahmen 31 kann ferner rund oder eckig ausgebildet sein.

Der MEMS-Schallwandler 3 kann ferner eine Abdeckung 32 umfassen, die auf der MEMS-Membraneinheit 29 und/oder auf dem Trägersubstrat 23 angeordnet ist. Die Abdeckung 32 bildet einen Deckel des Tweeters 3. Die Abdeckung 32 weist eine Abdeckdurchführung 33 auf, so dass der erzeugte Schall austreten kann. Die Abdeckdurchführung 33 kann ebenfalls zumindest teilweise, insbesondere vollständig, das Vordervolumen des Tweeters 3 bilden.

Der MEMS-Schallwandler 3 umfasst ferner eine MEMS-Kavität 54. An die MEMS-Kavität 54, wenn der MEMS-Schallwandler 3, wie in Figur 1 gezeigt ist, in der Schallwandlereinheit 1 angeordnet ist, schließt die Elektronikdurchführung 19 an. Die MEMS-Kavität 54 weist somit, wie in Figur 3 zu sehen ist, Kontakt mit dem Verschlussteilhohlraum 45 auf. Hierdurch bildet die Elektronikdurchführung 19 und/oder der Verschlussteilhohlraum 45 ein Hintervolumen des MEMS-Schallwandlers 3.

Des Weiteren umfasst der MEMS-Schallwandler 3 eine MEMS-Leiterplatte 60. Diese MEMS-Leiterplatte 60 ist dem MEMS-Schallwandler 3 zugeordnet. Mit Hilfe der MEMS-Leiterplatte 60 können beispielsweise elektrische Signale zu den Piezoschichten 24 geleitet werden bzw. mittels der MEMS-Leiterplatte 60 können die elektrischen Signale verteilt werden. Die MEMS-Leiterplatte 60 weist außerdem einen Leiterplattenhohlraum 61 auf. Dieser kann zumindest teilweise ein Hintervolumen des MEMS-Schallwandlers 3 bilden. Des Weiteren kann das Trägersubstrat 23 auf der MEMS-Leiterplatte 60 angeordnet sein.

Figur 3 zeigt einen Querschnitt des In-Ear Hörers 34. Im In-Ear Hörer 34 ist die Schallwandlereinheit 1 angeordnet, mit der der Schall erzeugt werden kann. Der In-Ear Hörer 34 ist ein Ausführungsbeispiel des Elektronikbauteils. Das Elektronikbauteil kann auch ein Kopfhörer, Smartphone, ein Laptop, ein Tablet, eine Smartwatch usw. sein.

Der hier als Elektronikbauteil gezeigte In-Ear Hörer 34 umfasst ein Hörergehäuse 35, in dem die Schallwandlereinheit 1 angeordnet ist. Das Hörergehäuse 35 ist gemäß dem vorliegenden Ausführungsbeispiel zweiteilig ausgebildet. Das Hörergehäuse 35 umfasst ein Ohrteil 36, welches bei vorgesehener Verwendung und Benutzung des In-Ear Hörers 34 in den Gehörgang des Benutzers eingeführt zu werden. Über das Ohrteil 36 kann noch ein Aufsatz, beispielsweise aus Silikon, aufgesetzt sein. Der Aufsatz bildet einen Ohrstöpsel, der dann in den Gehörgang zumindest teilweise eingeführt wird. Der Aufsatz kann aus einem flexiblen und hautverträglichen Material ausgebildet sein. Zusätzlich ist es von Vorteil, wenn dieser Aufsatz bzw. der Ohrstöpsel derart ausgebildet ist, dass es sich an den Gehörgang anpasst oder dass es bereits an den Gehörgang angepasst ist.

Das Ohrteil 36 weist ferner eine Auslassöffnung 43 auf, durch die der Schall des elektrodynamischen und des MEMS-Schallwandlers 2, 3 aus dem Ohrteil 36 bzw. aus dem Hörergehäuse 35 austreten kann. Vorteilhafterweise ist die Auslassöffnung 43 mit einem Abdichtelement 38 verschlossen, so dass das Eintreten von Schmutz verhindert ist. Das Abdichtelement 38 kann beispielsweise ein Gitter, ein Netz oder ein Schaumstoff sein, so dass das Durchtreten von Schall ermöglicht ist, Schmutz aber zurückgehalten wird.

Weiterhin führt das Schallleitelement 16 bis an die Auslassöffnung 43 heran, so dass der Schall des MEMS-Schallwandlers 3 bis zur Auslassöffnung 43 geführt werden kann.

Wie hier ferner zu sehen ist, ist das Schallleitelement 16 derart angeordnet, dass der Schall des elektrodynamischen Schallwandlers 2 am Schallleitelement 16 vorbeigeführt wird. Der Schall des MEMS-Schallwandlers 3 wird hingegen vom Schallleitelement 16 geleitet. Der Schall wird innerhalb des Schallleitelements 16 geleitet. Durch das Schallleitelement 16 bleiben die Schallwellen des Woofers 2 und die Schallwellen des Tweeters 3 innerhalb des Hörergehäuses 35 voneinander getrennt.

Des Weiteren ist zwischen dem Ohrteil 36 und dem Schallleitelement 16 zumindest ein Abstandshalter 40 angeordnet, wobei in dieser Figur 3 zwei Abstandhalter 40a, 40b gezeigt sind. Hierdurch kann der Schall des elektrodynamische Schallwandlers 2 am Schallleitelement 16 vorbeigeführt werden. Außerdem kann hierdurch erreicht werden, dass das Schallleitelement 16, insbesondere koaxial, zum Ohrteil 36 orientiert bleibt. Der Schall wird dann gut in den Gehörgang eingeleitet.

Des Weiteren umfasst das Hörergehäuse 35 ein Verschlussteil 37, welches den In-Ear Hörer 34 verschließt. Hierdurch kann verhindert werden, dass Feuchtigkeit oder Wasser an die Schallwandlereinheit 1 gelangt. Das Verschlussteil 37 kann ferner eine Leitungsdurchführung 39 aufweisen, durch die elektrische Leitung, beispielsweise von einer Batterie oder sonstigen elektronischen Bauteilen, an die Schallwandlereinheit 1 herangeführt werden kann. Auf die Leitungsdurchführung 39 kann verzichtet werden, wenn die Schallwandlereinheit 1 beispielsweise über eine kabellose Verbindung mit Audiosignalen etc. versorgt wird. Das Verschlussteil 37 kann somit verschlossen sein, so dass auch keine Feuchtigkeit eindringen kann. Alternativ kann eine Öffnung trotzdem vorteilhaft sein, um beim Betrieb der Schallwandlereinheit 1 einen Druckausgleich für die beiden Schallwandler 2, 3 zu schaffen.

Des Weiteren weist das Ohrteil 36 einen Ohrteilhohlraum 44 auf. Dieses bildet ein Vordervolumen des Woofers 2 und/oder durch den Ohrteilhohlraum 44 werden die Schallwellen des Woofers 2 zur Auslassöffnung 43 und/oder am Schallleitelement 16 vorbei geführt. Zusätzlich weist das Verschlussteil 37 einen Verschlussteilhohlraum 45 auf. Dieser kann ein Hintervolumen des Tweeters 3 und/oder des Woofers 2 bilden.

As Ohrteil 36 umschließt ferner das Wandlergehäuse 4 und/oder den äußeren Membranträger 13. Beispielsweise kann zwischen Wandlergehäuse 4 und/oder dem äußeren Membranträger 13 und dem Ohrteil 36 und/oder dem Verschlussteil 37 eine Klebeverbindung ausgebildet sein. Vorteilhaft ist es, wenn die Schallwandlereinheit 1 ein hier nicht gezeigtes Schutzelement umfasst, das um das Wandlergehäuse 4 angeordnet ist und sich zumindest teilweise in Radialrichtung 22 von außen her über die erste Membran 10 erstreckt. Hierdurch wird die erste Membran 10 geschützt, wobei das Schutzelement von der ersten Membran 10 in Axialrichtung beabstandet ist. Die besagte Klebeverbindung kann dann zwischen dem Schutzelement und dem Ohrteil 36 und/oder dem Verschlussteil 37 bestehen.

Des Weiteren ist in diesem Ausführungsbeispiel am Schallleitelement 16 und/oder am zumindest einen Abstandshalter 40 ein Dämpfungsmaterial 69 angeordnet. Wie weiterhin hier zu sehen ist, ist das Dämpfungsmaterial 69 derart angeordnet, dass es bei vorgesehener Anordnung der Schallwandlereinheit 1 im Elektronikbauteil, beispielsweise dem hier gezeigten In-Ear-Hörer 34, zwischen dem Schallleitelement 16 und dem umgebenden Gehäuse, Abschnitt des Elektronikbauteils bzw. dem hier gezeigten Ohrteil 36 angeordnet ist. Die vom elektrodynamischen Schallwandler 2 abgestrahlten Schallwellen durchlaufen infolgedessen auf dem Weg zur Austrittsöffnung 43 das Dämpfungsmaterial 69. Hierdurch kann die Tonqualität verbessert werden, indem der Klang durch das Dämpfungsmaterial beeinflusst wird. Das Dämpfungsmaterial 69 kann hierbei beispielsweise ein Schaumstoff oder ein Mesh sein.

Figur 4 zeigt einen Querschnitt des elektrodynamischen Schallwandlers 2. Der besseren Übersichtlichkeit halber ist hier der MEMS-Schallwandler 3 weggelassen.

Hier ist der Wandlerhohlraum 41 gezeigt, der in der Mitte des Woofers 2 angeordnet ist. Das erste Polelement 5 erstreckt sich um den Wandlerhohlraum 41 herum und begrenzt diesen. In den Wandlerhohlraum 41 wird der MEMS-Schallwandler 3 angeordnet. Im ersten Polelement 5 ist ferner die Schallkavität angeordnet, in die der Tweeter 3 den Schall aussenden. Gemäß Figur 1 schließt an die Schallkavität 17 das Schallleitelement 16, welches vorzugsweise als Schallleitkanal ausgebildet ist, an.

Des Woofers 2 umfasst ferner einen Schwinghohlraum 46, in dem die Spule 8 und/oder die erste Membran 10 in Axialrichtung 21 schwingen kann. Mittels des Schwinghohlraums 46 kann sich die erste Membran 10 in Richtung erstes Polelement 5 und/oder in Richtung des Tweeters 3 bewegen, wenn die erste Membran 10 schwingt. Der Schwinghohlraum 46 geht im Bereich der Spule 8 in den Magnetspalt 14 über.

Außerdem ist hier der Membrandurchbruch 42 gezeigt. Dieser bildet zusammen mit der Schallkavität 17, dem Wandlerhohlraum 41 und/oder zumindest teilweise mit dem Schwinghohlraum 46 die Öffnung des elektrodynamischen Schallwandlers 2. Durch den Membrandurchbruch 42 ist auch das Schallleitelement 16 geführt.

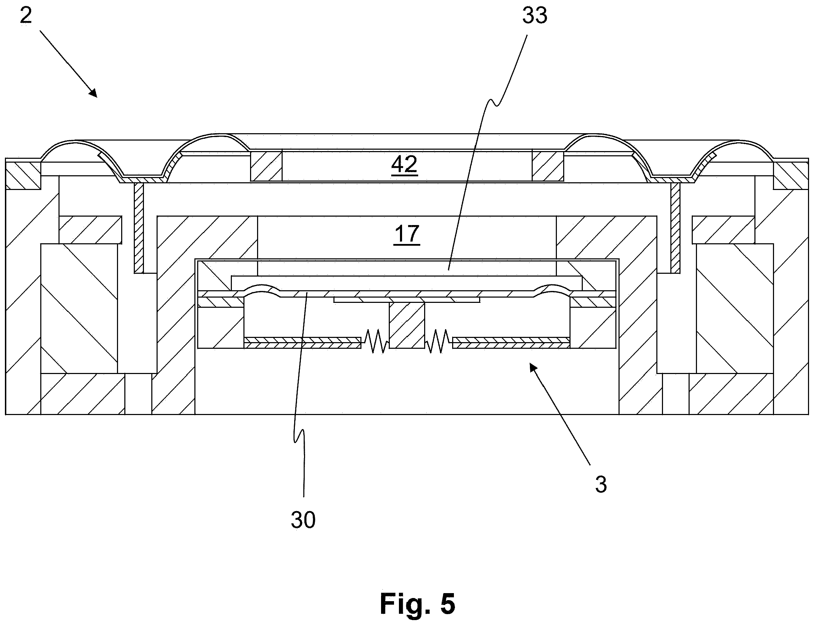

Figur 5 zeigt einen Querschnitt des elektrodynamischen und des MEMS-Schallwandlers 2, 3. Hier sind der Übersichtlichkeit halber die meisten Bezugszeichen weggelassen. Hier ist ferner der MEMS-Schallwandler 3 detailliert gezeigt. Die Merkmale sind in Figur 2 näher beschrieben. Wie hier zu sehen ist, weist die zweite Membran 30 eine Fläche auf, die mindestens so groß ist, wie eine Fläche des Membrandurchbruchs 42. Hier ist die Fläche der zweiten Membran 30 größer als die Fläche des Membrandurchbruchs 42.

Des Weiteren ist die der zweiten Membran 30 mindestens so groß wie eine Fläche der Abdeckdurchführung 33 und/oder der Schallkavität 17. Des Weiteren ist, wie anhand der Figur 5 in Verbindung mit der Figur 1 zu sehen ist, die Fläche der zweiten Membran 30 größer als eine Querschnittsfläche des Schallleitelements 16 und ist mindestens so groß wie eine Querschnittsfläche der Schallkavität 17.

Vorzugsweise sind die Abdeckdurchführung 33 und die Schallkavität 17 in der Magneteinheit 52, insbesondere im ersten Polelement 5, zueinander deckungsgleich und/oder bündig.

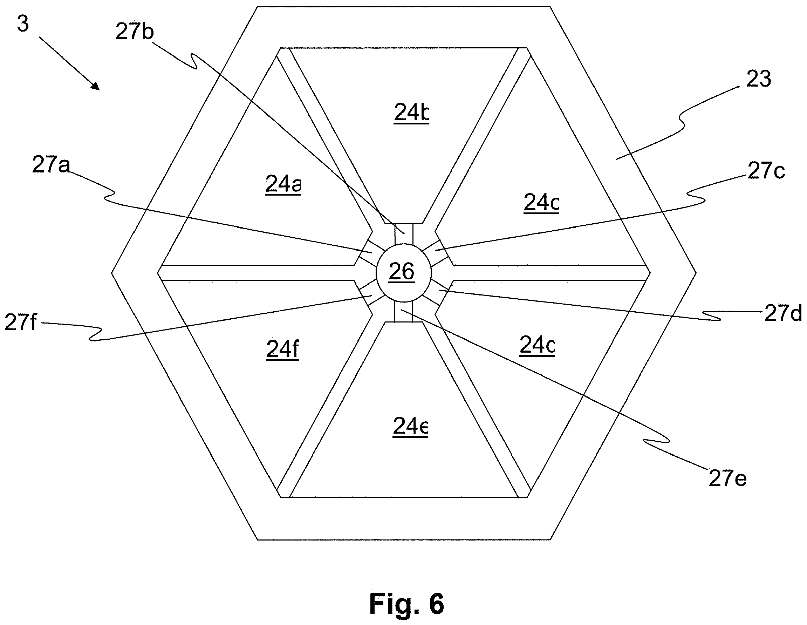

Figur 6 zeigt eine Draufsicht auf einen MEMS-Schallwandler 3. Im vorliegenden Ausführungsbeispiel ist der MEMS-Schallwandler 3 polygonförmig ausgebildet. Hier ist der MEMS-Schallwandler 3 sechseckig. Der MEMS-Schallwandler 3 weist infolgedessen sechs Trägerschichten 24a - 24f auf. Außerdem weist der MEMS-Schallwandler 3 auch sechs Piezoschichten 25 auf, die hier jedoch durch die Trägerschichten 24a - 24f verdeckt sind. Jeder der Piezoschichten 25 und Trägerschichten 24a - 24f ist mittels einem Federelement 27a - 27f mit dem Koppelelement 26 verbunden. Auf dem hier gezeigten Trägersubstrat 23 ist dann die MEMS-Membraneinheit 29 mit der zweiten Membran 30 angeordnet. Die MEMS-Membraneinheit 29 und die zweite Membran 30 weisen hierbei eine zum Trägersubstrat 23 passende Form auf. Insbesondere sind MEMS-Membraneinheit 29 und die zweite Membran 30 wie hier sechseckig. Durch die hier gezeigte Form kann der MEMS-Schallwandler 3 an den runden Wandlerhohlraum 41 angepasst werden. Durch die mehrere Träger- und Piezoschichten 24, 25 kann die zweite Membran 30 stärker ausgelenkt werden. Ein Schalldruck kann hierdurch erhöht werden.

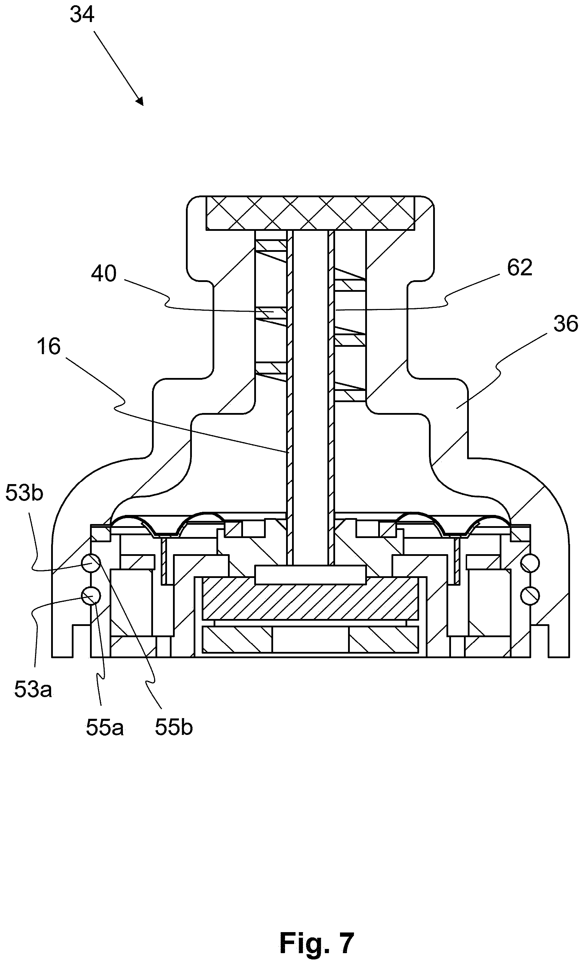

Figur 7 zeigt einen Querschnitt des In-Ear Hörers 34 bzw. der Schallwandlereinheit 1 mit einem Ausführungsbeispiel des Abstandshalters 40 und mit zumindest einem Dichtelement 53. Der Einfachheit halber sind nur noch die wichtigsten Merkmale mit einem Bezugszeichen versehen. Außerdem ist das Verschlussteil im Vergleich zur Figur 3 nicht mehr gezeigt.

Hier umfasst die Schallwandlereinheit 1 zumindest ein Dichtelement 53, mit dem die Schallwandlereinheit 1 abdichtend in das Hörergehäuse 35 eingesetzt werden kann. Wie hier zu sehen ist, ist das Dichtelement 53 am Wandlergehäuse 4 angeordnet. Wenn das Dichtelement 53 am Wandlergehäuse 4 angeordnet ist, kann es gemäß Figur 3 verhindern, dass Feuchtigkeit vom Ohrteilhohlraum 44 zum Verschlussteilhohlraum 45 gelangt. Das Dichtelement 53 kann, wie hier gezeigt ist, ringförmig sein. Zusätzlich oder alternativ kann mit Hilfe des zumindest einen Dichtelements 53 auch verhindert werden, das Schall zwischen dem Ohrteilhohlraum 44 und dem Verschlussteilhohlraum 45 ausgetauscht wird. Ferner ist das Dichtelement 53 hier in einer Gehäusenut 55 des Wandlergehäuses 4 angeordnet. Das Dichtelement 53 kann beispielsweise ein Gummi- oder Silikonring sein. Des Weiteren kann die Schallwandlereinheit 1 auch mehrere in Axialrichtung voneinander beabstandete Dichtelemente 53 aufweisen. Hier sind zwei Dichtelemente 53a, 53b gezeigt. Das zumindest eine Dichtelement 53 kann als Dichtring ausgebildet sein. Das zumindest eine Dichtelement 53 und/oder die Gehäusenut 55 kann an einer Umfangsseite 70 der Schallwandlereinheit 1 und/oder des Wandlergehäuses 4 angeordnet sein.

Des Weiteren ist hier ein Ausführungsbeispiel des Abstandshalters 40 gezeigt. Der zumindest eine Abstandshalter 40 ist an einer Außenseite 68 des Schallleitkanals 16 angeordnet.

Der zumindest eine Abstandshalter 40 ist hier derart ausgebildet und/oder angeordnet, dass damit der vom elektrodynamischen Schallwandler 2 erzeugte Schall zur Auslassöffnung 43 geführt wird. Hier weist der Abstandshalter 40 die Form einer Helix auf, die um das Schallleitelement 16 herum angeordnet ist und sich in Axialrichtung 21 entlang dem Schallleitelement 16 erstreckt. Hierdurch wird verhindert, dass der Schall des elektrodynamischen Schallwandlers 2 auf direktem, insbesondere dem kürzesten Weg, zur Auslassöffnung 43 gelangt. Der Weg für den Schall wird dadurch verlängert bzw. verändert, wobei sich der Schall verändert, so dass der Schall angepasst werden kann. Zusätzlich oder alternativ können mehrere Abstandshalter 40 auch in Axial- und Radialrichtung 21, 22 voneinander beabstandet angeordnet sein, so dass der Schall auf einen Zick-Zack-Weg zur Auslassöffnung 43 gelangt.

Der zumindest eine Abstandshalter 40 kann somit derart ausgebildet sein, dass dieser ein Labyrinth für den vom elektrondynamischen Schallwandler 2 erzeugten Schall bildet. Mit Hilfe des Labyrinths kann der Schall auf dem Weg zur Auslassöffnung 43 umgelenkt werden, so dass der Schall verändert werden kann. Der labyrinthförmige Abstandshalter 40 ist zwischen dem Schallleitelement 16 und dem Ohrteil 36 oder einem Gehäuseteil, wenn das Elektronikbauteil kein in-Ear-Hörer 34 ist, angeordnet. Um das Labyrinth auszubilden, können vorteilhafterweise mehrere Abstandshalter 40 in Axialrichtung und/oder in Radialrichtung 21, 22 beabstandet zueinander angeordnet werden.

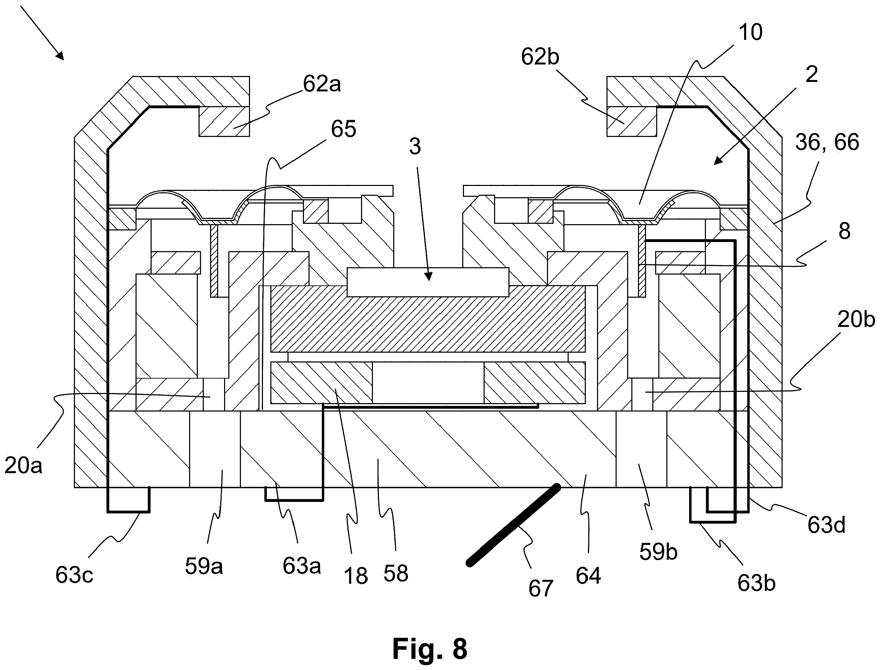

Figur 8 zeigt einen Querschnitt der Schallwandlereinheit 1 mit Mikrofonen 62. Des Weiteren umfasst die Schallwandlereinheit 1 die Elektronikeinheit 18, den MEMS-Schallwandler 3 und eine Leiterplatte 58. Elemente der Elektronikeinheit 18 können auch in der Leiterplatte 58 angeordnet sein. Die hier schematisch gezeigte Elektronikeinheit 18 kann dann die in Figur 2 gezeigte MEMS-Leiterplatte 60 mit dem Leiterplattenhohlraum 61 sein. Die Elektronikdurchführung 19 kann dann ein Leiterplattenhohlraum 61 der Leiterplatte sein. Diese Ausführung der MEMS-Leiterplatte 60, der Elektronikeinheit 18 und/oder der Leiterplatte 58 können auch in den Ausführungen der anderen Figuren vorhanden sein. Somit kann die Schallwandlereinheit 1 die Elektronikeinheit 18, die MEMS-Leiterplatte 60 und/oder die Leiterplatte 58 aufweisen, wobei insbesondere die Elemente der Elektronikeinheit 18 in der MEMS-Leiterplatte 60 und/oder in der Leiterplatte 58 angeordnet sein können. Die hier gezeigte Elektronikeinheit 18 und der MEMS-Schallwandler 3 können den MEMS-Schallwandler 3 der Figur 2 bilden, wobei die Elektronikeinheit 18 die MEMS-Leiterplatte 60 ist.

Des Weiteren umfasst die hier gezeigte Schallwandlereinheit 1 zumindest ein Mikrofon 62, wobei hier zwei Mikrofone 62a, 62b gezeigt sind. Das zumindest eine Mikrofon 62 ist hier derart angeordnet, dass die vom elektrodynamischen Schallwandler 2 abgestrahlten Schallwellen zu dem zumindest einen Mikrofon 62 gelangen. Hierbei kann das zumindest eine Mikrofon 62 der ersten Membran 10 zugewandt sein, so dass die Schallwellen auf direkten bzw. unmittelbaren Weg zum zumindest einen Mikrofon 62 gelangen. Das zumindest eine Mikrofon 62 kann ein Rückkopplungsmikrofon sein. Mit dem zumindest einen Mikrofon 62 kann die Tonqualität der Schallwellen überwacht werden, die vom elektrodynamischen Schallwandler 2 abgestrahlt werden. Zusätzlich oder alternativ kann das zumindest eine Mikrofon 62 auch Umgebungsgeräusche in einer Umgebung der Schallwandlereinheit 1 und/oder in der Umgebung des Elektronikbauteils, beispielsweise des Kopfhörers, Smartphones, Tablets, Laptops, etc., erfassen. Aus dem erfassten Umgebungsgeräuschen kann ein Antischall ausgebildet werden, der vom elektrodynamischen Schallwandler 2 und/oder vom MEMS-Schallwandler 3 erzeugt wird. Hierdurch können die Umgebungsgeräusche ausgelöscht werden. Hiermit kann ein Active-Noise-Cancelling-Verfahren erfolgen. Beim Elektronikbauteil, beispielsweise beim In-Ear-Hörer 34, wie er in Figur 3 gezeigt ist, kann auch noch ein weiteres Mikrofon 62 vorhanden sein. Dieses kann einer Umgebung des Elektronikbauteils, beispielsweise einer Umgebung des In-Ear-Hörers 34 bzw. einer Umgebung des Trägers des In-Ear-Hörers 34, zugewandt sein, um einen Antischall zu erzeugen, um Umgebungsgeräusche zu unterdrücken.

Das zumindest eine Mikrofon 62 ist hier am Ohrteil 36 angeordnet, dass hier teilweise gezeigt ist. Das Ohrteil 36 ist hier eine spezielle Ausführung eines Gehäuseteils 66. Die Schallwandlereinheit 1 umfasst das Gehäuseteil 66 oder ist in dem Gehäuseteil 66 angeordnet. Das Gehäuseteil 66 kann Teil des Elektronikbauteils sein. Wenn das Elektronikbauteil der In-Ear-Hörer 34 ist, dann ist das Gehäuseteil 66 das Ohrteil 36.

Zusätzlich oder alternativ kann das zumindest eine Mikrofon 62 auch an einer Einhausung, insbesondere eine Schutzeinhausung, für die Schallwandlereinheit 1 angeordnet sein, wobei die Einhausung als Schutz für die Schallwandlereinheit 1 und insbesondere für die erste Membran 10 des elektrodynamischen Schallwandlers 2 dient. Das hier gezeigte Gehäuseteil 66 und/oder das Ohrteil 36 können hier als die Einhausung dienen bzw. kann die Einhausung durch das Gehäuseteil 66 und/oder das Ohrteil 36 ausgebildet sein.

Außerdem sind in diesem Ausführungsbeispiel mehrere Leitungen 63a - 63d schematisch gezeigt. Bei den Leitungen 63a - 63d kann es sich um, insbesondere mehradrige, Kabel bzw. Leitungen 63a - 63d handeln. Mit Hilfe der Leitungen 63a - 63d können die für den Betrieb der Schallwandlereinheit 1 vorgesehenen elektrischen Signale verteilt werden. Eine erste Leitung 63a führt zur Elektronikeinheit 18 und/oder zum MEMS-Schallwandler 3. Eine zweite Leitung 63b führt zur Spule 8 des elektrodynamischen Schallwandlers 2. Eine dritte Leitung 63c führt zum hier gezeigten ersten Mikrofon 62a und eine vierte Leitung 63d führt zum hier gezeigten zweiten Mikrofon 62b. Die Leitungen 63a - 63d sind hier mit der Leiterplatte 58 gekoppelt. Wie hier weiterhin zu sehen ist, sind die Leitungen 63a - 63d auf einer Rückseite 64 der Leiterplatte 58 mit dieser gekoppelt.

Die Leitungen 63a - 63d können hier in geeigneten Kanälen angeordnet sein. Wie hier zu sehen ist, sind die beiden Leitungen 63c, 63d zwischen dem Wandlergehäuse 4 und dem Ohrteil 36 bzw. dem Gehäuseteil 66 angeordnet.

Die Leiterplatte 58 kann ferner einen Anschluss 67 aufweisen, über die elektrischen Signale von einer externen Einheit zur Schallwandlereinheit 1 zu leiten. Der Anschluss 67 kann hierbei als ein flexibler Abschnitt, beispielsweise als ein Flex-PCB, ausgebildet sein, so dass der Anschluss 67 gedreht bzw. gebogen werden kann, um die Verbindung mit dem Anschluss 67 aus verschiedenen Richtungen zu ermöglichen. Der Anschluss 67 ist hier auf einer Rückseite 64 der Leiterplatte 58 angeordnet. Der Anschluss 67 kann auch einen Stecker umfassen und/oder als Stecker ausgebildet sein. Der Stecker kann hierbei ein Flachstecker sein und/oder kann auf der Leiterplatte 58 angelötet sein.

Des Weiteren kann der Stecker, insbesondere als Flachstecker, auch auf einer Vorderseite 65 der Leiterplatte 58 angeordnet sein. Die Vorderseite 65 ist hier dem MEMS-Schallwandler 3 und/oder der Elektronikeinheit 18 zugewandt. Der Stecker wird dann durch die Leiterplatte 58, beispielsweise durch eine Leiterplattendurchführung 59, hindurchgeführt.

Der Flachstecker kann beispielsweise als flexible Leiterplatte ausgebildet sein, so dass der Stecker bzw. der Flachstecker flach auf der Leiterplatte 58 angeordnet werden kann. Hierdurch kann der Stecker bzw. der Flachstecker auch zwischen der Leiterplatte 58 und dem MEMS-Schallwandler 3 und/oder der Elektronikeinheit 18, insbesondere auf der Vorderseite 65 der Leiterplatte 58, angeordnet werden. Zusätzlich oder alternativ kann hierdurch der Stecker auch mit dem MEMS-Schallwandler 3 und/oder der Elektronikeinheit 18 gekoppelt werden.

Die vorliegende Erfindung ist nicht auf die dargestellten und beschriebenen Ausführungsbeispiele beschränkt. Abwandlungen im Rahmen der Patentansprüche sind ebenso möglich wie eine Kombination der Merkmale, auch wenn diese in unterschiedlichen Ausführungsbeispielen dargestellt und beschrieben sind.

### Bezugszeichenliste

- 1: Schallwandlereinheit
- 2: elektrodynamischer Schallwandler / Woofer /Tieftöner
- 3: MEMS-Schallwandler / Tweeter / Hochtöner
- 4: Wandlergehäuse
- 5: erstes Polelement
- 6: zweites Polelement
- 7: Magnet
- 8: Spule
- 9: Membraneinheit
- 10: erste Membran
- 11: Koppeleinheit
- 12: innere Membranträger
- 13: äußere Membranträger
- 14: Magnetspalt
- 15: Halter
- 16: Schallleitelement
- 17: Schallkavität
- 18: Elektronikeinheit
- 19: Elektronikdurchführung
- 20: Poldurchführung
- 21: Axialrichtung
- 22: Radialrichtung
- 23: Trägersubstrat
- 24: Trägerschicht
- 25: Piezoschicht
- 26: Koppelelement
- 27: Federelement
- 28: Koppelplatte
- 29: MEMS-Membraneinheit
- 30: zweite Membran
- 31: MEMS-Membranrahmen
- 32: Abdeckung
- 33: Abdeckdurchführung
- 34: In-Ear Hörer
- 35: Hörergehäuse
- 36: Ohrteil
- 37: Verschlussteil
- 38: Abdichtelement
- 39: Leitungsdurchführung
- 40: Abstandshalter
- 41: Wandlerhohlraum
- 42: Membrandurchbruch
- 43: Auslassöffnung
- 44: Ohrteilhohlraum
- 45: Verschlussteilhohlraum
- 46: Schwinghohlraum
- 52: Magneteinheit
- 53: Dichtelement
- 54: MEMS-Kavität
- 55: Gehäusenut
- 56: erste Kontaktfläche
- 57: zweite Kontaktfläche
- 58: Leiterplatte
- 59: Leiterplattendurchführung
- 60: MEMS-Leiterplatte
- 61: Leiterplattenhohlraum
- 62: Mikrofon
- 63: Leitung
- 64: Rückseite
- 65: Vorderseite
- 66: Gehäuseteil
- 67: Anschluss
- 68: Außenseite
- 69: Dämpfungsmaterial
- 70: Umfangsseite

## Patentansprüche

1. Schallwandlereinheit (1), insbesondere für einen In-Ear Hörer,
mit einem elektrodynamischen Schallwandler (2), der eine erste Membran (10), vorzugsweise mit einem Membrandurchbruch (42), aufweist, und
mit zumindest einem MEMS-Schallwandler (3), der eine zweite Membran (30) aufweist, **dadurch gekennzeichnet,**
**dass** die Schallwandlereinheit (1) ein Schallleitelement (16) umfasst, mittels dem vom MEMS-Schallwandler (3) erzeugte Schallwellen am elektrodynamischen Schallwandler (2), insbesondere an der ersten Membran (10) des elektrodynamischen Schallwandlers (2), vorbeigeführt werden können.

2. Schallwandlereinheit gemäß dem vorangegangenen Anspruch,
**dadurch gekennzeichnet, dass** der MEMS-Schallwandler (3) derart in den elektrodynamischen Schallwandler (2) integriert ist, dass die von der zweiten Membran (30) erzeugbaren Schallwellen über den Membrandurchbruch (42) aus der Schallwandlereinheit (1) ausführbar sind.

3. Schallwandlereinheit gemäß einem der vorangegangenen Ansprüche, **dadurch gekennzeichnet, dass** der elektrodynamische Schallwandler (2) um den zumindest einen MEMS-Schallwandler (3) herum angeordnet ist und/oder
dass die erste Membran (10) ringförmig ausgebildet ist und/oder dass der elektrodynamische Schallwandler (2) ringförmig ausgebildet ist und/oder
dass der MEMS-Schallwandler (3) in einem Durchgangsloch des Torus angeordnet ist.

4. Schallwandlereinheit gemäß einem der vorangegangenen Ansprüche, **dadurch gekennzeichnet, dass** das Schallleitelement (16) ein Schallleitrohr ist und/oder
dass sich das Schallleitelement (16) durch den elektrodynamischen Schallwandler (2) und/oder den Membrandurchbruch (42) hindurch erstreckt und/oder
dass das Schallleitelement (16) über die erste Membran (10) übersteht und/oder als Fortsatz ausgebildet ist, der über die erste Membran (10) hinausragt und/oder
dass das Schallleitelement (16) gerade oder gekrümmt ist.

5. Schallwandlereinheit gemäß einem der vorangegangenen Ansprüche, **dadurch gekennzeichnet, dass** an einer Außenseite (62) des Schallleitelements (16) zumindest ein Abstandshalter (40) angeordnet ist, um bei vorgesehener Anordnung der Schallwandlereinheit (1) in einem Elektronikbauteil, insbesondere einem In-Ear-Hörer (34), das Schallleitelement (16) von einem umgebenden Gehäuseteils des Elektronikbauteils zu beabstanden.

6. Schallwandlereinheit gemäß einem der vorangegangenen Ansprüche, **dadurch gekennzeichnet, dass** der zumindest eine Abstandshalter (40) labyrinthförmig und/oder helixförmig ausgebildet ist.

7. Schallwandlereinheit gemäß einem der vorangegangenen Ansprüche, **dadurch gekennzeichnet, dass** an der Außenseite (68) des Schallleitelements (16) und/oder am Abstandshalter (40) ein Dämpfungsmaterial (69) angeordnet ist.

8. Schallwandlereinheit gemäß einem der vorangegangenen Ansprüche, **dadurch gekennzeichnet, dass** die Schallwandlereinheit (1) einen Wandlerhohlraum (41) aufweist, in dem der MEMS-Schallwandler (3) und/oder eine Elektronikeinheit (18) angeordnet ist, wobei der Wandlerhohlraum (41) vorzugsweise zumindest teilweise durch das Durchgangsloch des ringförmigen elektrodynamischen Schallwandlers gebildet ist und/oder
dass der Wandlerhohlraum (41) von einer Magneteinheit (52), insbesondere einem Magneten (7), des elektrodynamischen Schallwandlers (2) umrandet ist und/oder
dass der MEMS-Schallwandler (3) und/oder die Elektronikeinheit (18) in Axialrichtung der Schallwandlereinheit (1) auf Höhe der Magneteinheit (52), insbesondere des Magneten (7), angeordnet ist..

9. Schallwandlereinheit gemäß einem der vorangegangenen Ansprüche, **dadurch gekennzeichnet, dass** der MEMS-Schallwandler (3), die Elektronikeinheit (18), ein Halter (15) und/oder das Schallleitelement (16) in Axialrichtung (21) der Schallwandlereinheit (1) einen Überdeckungsbereich mit einer Magneteinheit (52), insbesondere einem Magneten (7), des elektrodynamischen Schallwandlers (2), einer Spule (8) des elektrodynamischen Schallwandlers (2) und/oder eines Wandlergehäuses (4) der Schallwandlereinheit (1) aufweisen.

10. Schallwandlereinheit gemäß einem der vorangegangenen Ansprüche, **dadurch gekennzeichnet, dass** der MEMS-Schallwandler (3) am Halter (15) der Schallwandlereinheit (1) und/oder an der Magneteinheit (52) des elektrodynamischen Schallwandlers (2) angeordnet ist und/oder mit diesen eine Kontaktfläche aufweisen.

11. Schallwandlereinheit gemäß einem der vorangegangenen Ansprüche, **dadurch gekennzeichnet, dass** die Elektronikeinheit (18) eine Elektronikdurchführung (19) aufweist, die sich an eine MEMS-Kavität (54) des MEMS-Schallwandlers (3) anschließt, und/oder dass die Schallwandlereinheit (1) zumindest ein Dichtungselement (53) aufweist, das vorzugsweise an einer Umgangsseite der Schallwandlereinheit (1) angeordnet ist, und/oder
dass die Schallwandlereinheit (1) zumindest einen Anschluss (67) umfasst, wobei der zumindest eine Anschluss (67) vorzugsweise als ein flexibler Anschlussabschnitt und/oder als Stecker ausgebildet ist, und/oder
dass die Schallwandlereinheit (1) zumindest ein Mikrofon (62) aufweist, mittels dem zumindest die vom elektrodynamischen Schallwandler (2) erzeugbaren Schallwellen und/oder Umgebungsgeräusche erfasst werden können.

12. Schallwandlereinheit gemäß einem der vorangegangenen Ansprüche, **dadurch gekennzeichnet, dass** eine Schallausbreitungsachse des elektrodynamischen Schallwandlers (2) und eine Schallausbreitungsachse des MEMS-Schallwandlers (3) zueinander koaxial angeordnet sind, insbesondere in Axialrichtung der Schallwandlereinheit (1).

13. Elektronikbauteil, insbesondere In-Ear-Hörer (34), mit einer Schallwandlereinheit (1) gemäß einem oder mehreren der vorherigen Ansprüche.

14. Elektronikbauteil gemäß dem vorangegangenen Anspruch, **dadurch gekennzeichnet, dass** das Elektronikbauteil eine Auslassöffnung (43) aufweist und/oder dass sich ein Schallleitelement (16) von einem Membrandurchbruch (42) bis zur Auslassöffnung (43) erstreckt.

15. Verwendung einer Schallwandlereinheit (1), die insbesondere gemäß einem der vorherigen Ansprüche ausgebildet ist, in einem Elektronikbauteil, insbesondere gemäß einem der vorherigen Ansprüche.
